# EUROPÄISCHE PATENTSCHRIFT

(11) **EP 0 923 172 B1**
(45) Veröffentlichungstag und Bekanntmachung des Hinweises auf die Patenterteilung: **26.06.2002**
(21) Anmeldenummer: 98121876.1
(22) Anmeldetag: 18.11.1998
(51) Int. Cl.: H01R 12/22, H01R 13/631

(54) **Anordnung betreffend eine elektrische und/oder elektronische Bauelemente tragende Elektrikplatte mit einem elektrischen Steckverbinder und einer Abdeckung**
Assembly for a circuit board comprising electric and / or electronic components, an electrical connector and a cover
Assemblage pour un circuit imprimé comprenant des composants électriques et / ou électroniques, un connecteur électrique ainsi qu'un couvercle

(30) Priorität: 11.12.1997 DE 29721908 U
(43) Veröffentlichungstag der Anmeldung: 16.06.1999
(73) Patentinhaber: Leopold Kostal GmbH & Co. KG, 58507 Lüdenscheid (DE)
(72) Erfinder: Buhle,Klaus, 58239 Schwerte (DE)
(74) Vertreter: Schröter & Haverkamp

(56) Entgegenhaltungen:
- EP-A- 0 691 704
- WO-A-97/31821
- DE-B- 1 072 675
- US-A- 4 678 006
- US-A- 5 611 372

## Beschreibung

Die Erfindung bezieht sich auf das Gebiet von elektrischen Steckverbindern zum Anschließen einer eingebauten elektrische und/oder elektronische Bauelemente tragenden Elektrikplatte. Insbesondere betrifft die Erfindung eine Anordnung betreffend eine elektrische und/oder elektronische Bauelemente tragende Elektrikplatte mit einem elektrischen Steckverbinder und mit einer die Elektrikplatte bedeckenden Abdeckung, welche Elektrikplatte unterhalb der Abdeckung angeordnet ist und welcher Steckverbinder zur Herstellung einer elektrischen Verbindung zwischen der Elektrikplatte zugeordneten Leiterbahnen und einer Anschlußleitung vorgesehen ist und eine von der Elektrikplatte abragende Anordnung erster Kontaktglieder umfaßt, mit welchen Kontaktgliedern die freien Enden der elektrischen Leiterbahnen verbunden sind, sowie eine an dem einen Ende einer Anschlußleitung befindliche, zur Erstellung einer elektrischen Verbindung mit den ersten Kontaktgliedern ausgebildete Anordnung von zweiten Kontaktgliedem umfaßt, welchem Steckverbinder eine durch eine Durchlaßöffnung der Abdeckung geführte Führungshülse mit außenseitig angeordneten Dichtmitteln zur Abdichtung der Führungshülse gegenüber der Abdeckung zugeordnet ist.

Derartige Anordnungen werden beispielsweise bei einem Einsatz von Getriebesteuersystemen für Kraftfahrzeuge benötigt. Auf der Elektrikplatte sind üblicherweise die für ein solches Getriebesteuersystem vorgesehenen elektrischen, mechanischen und/oder hydraulischen Steuermittel sowie eine diesen Steuermitteln funktional zugeordnete Steuerelektronik angeordnet. Damit Leitungswege zwischen den Steuermitteln und den zu steuernden Getriebeeinheiten möglichst kurz sind, ist eine solche Elektrikplatte üblicherweise in das Gehäuse eines Getriebes integriert. Entweder ist die Elektrikplatte unmittelbar an dem Getriebegehäuse befestigt oder stützt sich auf einer Zwischenwand des Getriebegehäuses ab.

Um die Steuerelektronik sowohl mit Strom als auch mit den notwendigen Steuersignalen versorgen zu können, muß eine elektrische Verbindung zwischen entsprechenden auf der Elektrikplatte angeordneten Anschlüssen und den im Kraftfahrzeuginnenraum befindlichen Steuersignalgebern hergestellt sein. Zu diesem Zweck werden elektrische Steckverbinder eingesetzt, die vielfach auch als Zentralstecker bezeichnet werden. Ein solcher Steckverbinder besteht üblicherweise aus einer Anordnung von einer Vielzahl von der Elektrikplatte zugeordneten Kontaktstiften und einem Buchsen aufweisenden Buchsengehäuse, welches an dem einen Ende einer Anschlußleitung angeordnet und auf die Kontaktstiftanordnung zur Herstellung der elektrischen Verbindung aufsteckbar ist. Ein solcher Zentralstecker ist beispielsweise aus der DE 43 44 584 C2 bekannt. Zum Ausgleich von Bewegungen, insbesondere Vibrationsbewegungen ist der Zentralstecker dieser bekannten Vorrichtung kardanisch in zwei diametral gegenüberliegenden Führungsnuten gelagert. An die Kontaktstifte sind Leiterbahnen angenietet, die in ihrem ersten Abschnitt freiliegen, damit durch den Anschluß der Leiterbahnen an den Zentralstecker die durch die kardanische Aufhängung gewonnene Bewegbarkeit nicht unnötigt beeinträchtigt wird. Nachteilig ist bei dieser Ausgestaltung jedoch, daß Vibrationsbewegungen von den freiliegenden Leiterbahnabschnitten aufgefangen werden müssen, so daß die Gefahr ihres Brechens besteht.

Eine weitere Anordnung betreffend eine elektrische und/oder elektronische Bauelemente tragende Elektrikplatte mit einem elektrischen Steckverbinder und einer die Elektrikplatte bedeckenden Abdeckung ist bekannt geworden, die mit Hilfe von Schrauben am Getriebegehäuse befestigt ist. Die an der Elektrikplatte angeordneten Kontaktstifte sind nach oben und somit von der verwendeten Befestigungswand des Getriebegehäuses wegweisend angeordnet. Diese Kontaktstiftanordnung, die üblicherweise etwa kreisförmig ausgebildet ist, ist von einer Führungshülse umgeben, deren Länge so bemessen ist, daß die Führungshülse aus einem zu montierenden, die Elektrikplatte abdeckenden Deckel oder einer Abdeckung herausragt. Die Führungshülse weist außenseitig einen Dichtring zur Abdichtung der Führungshülse gegenüber der Abdeckung auf. Da zwischen dem Deckel und der Führungshülse eine Abdichtung gewährleistet sein muß und da bestimmte Toleranzen hinsichtlich der Anordnung der der Elektrikplatte zugeordneten Führungshülse und des Deckels bzw. der Abdeckung ebenso wie getriebeimmanente Vibrationen nicht vermeidbar sind, müssen bei der Montage vorgegebene Toleranzen sowie betriebsbedingte Bewegungen durch diese Dichtung aufgefangen werden. Demzufolge ist der die Führungshülse umgebende Randspalt entsprechend groß bemessen und muß, wie bei der vorbekannten Anordnung vorgesehen, durch eine im Querschnitt große Dichtung (O-Ring mit einem Querschnitt von etwa mit 6 bis 8 mm) ausgeglichen werden. Bei einem Einsatz einer solchen Anordnung in einem Getriebe eines Kraftfahrzeuges sind an eine solche Dichtung hohe Anforderungen hinsichtlich ihrer Temperaturbeständigkeit sowie hinsichtlich eines chemisch inerten Verhaltens gegenüber angreifenden Getriebeölen gefordert. Solche O-Ringe sind daher beispielsweise aus Fluorsilikon hergestellt.

Nachteilig ist bei dieser vorbekannten Anordnung jedoch, daß eine Elektrikplatte montage- und toleranzbedingt nur selten völlig spannungsfrei durch einen Deckel oder eine Abdeckung der genannten Art abgedeckt werden kann; zudem sind die Kosten für die verwendeten O-Ringe hoch.

Ausgehend von diesem diskutierten Stand der Technik liegt der Erfindung daher die Aufgabe zugrunde, eine gattungsgemäße Anordnung bereitzustellen, bei der nicht nur eine spannungsfreie Montage der Elektrikplatte unterhalb einer Abdeckung gewährleistet ist, sondern bei der ebenfalls die vorgesehenen abdeckungsseitigen Dichtmaßnahmen vereinfacht sind.

Diese Aufgabe wird erfindungsgemäß dadurch gelöst, daß an der von der Abdeckung abgewandten Seite der Elektrikplatte nachgiebige Abstützelemente vorgesehen sind und daß der Elektrikplatte und der Abdeckung jeweils zusammenwirkende Befestigungsmittel zur Erstellung einer mechanischen Verbindung zwischen der Elektrikplatte und der Abdeckung zugeordnet sind.

Da der erfindungsgemäßen Elektrikplatte unterseitig nachgiebige Abstützelemente zugeordnet sind, wobei eine Nachgiebigkeit sowohl in vertikaler, zum Abstützgrund hin gerichteter, als auch in horizontaler Richtung vorgesehen ist, läßt sich die Elektrikplatte innerhalb des durch die Abstützelemente vorgegebenen Bewegungsradius in diejenige Position bringen, in der die Führungshülse exakt mit der in der Abdeckung vorgesehenen Durchlaßöffnung fluchtet. Die Elektrikplatte kann somit spannungsfrei montiert werden, wodurch die Lebensdauer einer solchen Elektrikplatte erheblich verlängert ist.

Ferner sind der Elektrikplatte sowie der Abdeckung zusammenwirkende Befestigungsmittel zugeordnet, die bei einer Montage zu einer festen mechanischen Verbindung zwischen der Elektrikplatte und der Abdeckung führen. Die Elektrikplatte ist daher maßgeblich abdeckungsseitig befestigt und wird nach ihrer Montage von der Abdeckung getragen. Die Befestigungsmittel dienen zweckmäßigerweise zugleich als Zentriermittel, mit denen sich die Elektrikplatte beim Montieren der Abdeckung hinsichtlich der in der Abdeckung eingebrachten Durchlaßöffnung zentrieren läßt. Als Befestigungsmittel können beispielsweise solche eingesetzt werden, durch die eine Preßverbindung hergestellt ist. Beispielsweise können der Abdeckung Kerbnagel ähnlich wirkende Elemente zugeordnet sein, die in der Elektrikplatte zugeordnete Buchsen eingepreßt werden. Die Befestigungsmittel sind vorteilhafterweise in einer bestimmten, die Führungshülse umgebenden radialen Anordnung angeordnet, da diese dann zur zentrischen Erstellung der Durchlaßöffnung in der Abdeckung verwendbar sind. Die nachgiebige unterseitige Abstützung der Elektrikplatte läßt sich beispielsweise durch einen Einsatz von Schraubenfedern realisieren. Dabei ist vorgesehen, den zwischen der Unterseite der Elektrikplatte und dem Abstützgrund einen kleinen Spalt zu belassen.

Weitere Vorteile der Erfindung sowie Weiterbildungen sind Bestandteil der übrigen Unteransprüche sowie der nachfolgen Beschreibung eines Ausführungsbeispieles. Es zeigen:
- **Fig. 1:**: eine Anordnung betreffend eine elektrische und/oder elektronische Bauelemente tragende Elektrikplatte mit einem elektrischen Steckverbinder und mit einer die Elektrikplatte bedeckenden Abdeckung gemäß einem ersten Ausführungsbeispiel,
- **Fig. 2:**: eine Anordnung betreffend eine elektrische und/oder elektronische Bauelemente tragende Elektrikplatte mit einem elektrischen Steckverbinder und mit einer die Elektrikplatte bedeckenden Abdeckung gemäß einer weiteren Ausgestaltung und
- **Fig. 3:**: eine Anordnung betreffend eine elektrische und/oder elektronische Bauelemente tragende Elektrikplatte mit einem elektrischen Steckverbinder und mit einer die Elektrikplatte bedeckenden Abdeckung gemäß noch einer weiteren Ausgestaltung.

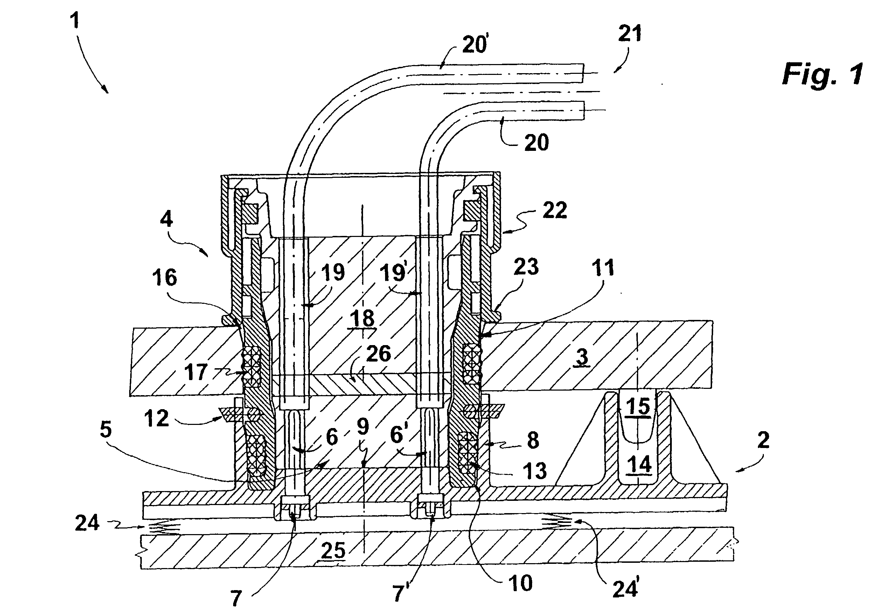

Die in Figur 1 gezeigte Anordnung 1 besteht im wesentlichen aus einer Elektrikplatte 2, einer Abdeckung 3 und einem elektrischen Steckverbinder 4. Zu dem elektrischen Steckverbinder 4 zählt ein der Elektrikplatte 2 zugeordneter Zentralstecker 5, der aus einer Anordnung von Kontaktstiften 6, 6' besteht. Die Kontaktstifte 6, 6' sind mit Preßsitz dicht in der Elektrikplatte 2 verankert, wobei den Kontaktstiften 6, 6' im Bereich ihres Preßsitzes nicht näher dargestellte Mausezähnchen zugeordnet sind. Die Kontaktstifte 6, 6' weisen unterseitig Nietbolzen 7, 7' auf, an denen die freien Enden von nicht näher dargestellten Leiterbahnen befestigbar sind. Auf der Elektrikplatte 2 ist an die Leiterbahnen die Steuerelektronik und weitere Steuermittel angeschlossen, die sämtlich nicht näher dargestellt sind.

Der Zentralstecker 5 wird von einem ringförmigen Steg 8 begrenzt. Der Steg 8 bildet zusammen mit dem Boden 9 des Zentralsteckers 5 eine ringförmige Nut 10 zur Aufnahme einer Führungshülse 11. Die Führungshülse 11 ist bei dem in Figur 1 dargestellten Ausführungsbeispiel durch eine Bügelklammer 12 mit dem Steg 8 verbunden. Zur Abdichtung der Führungshülse 11 gegenüber der Innenseite des Steges 8 ist in einer in die Führungshülse 11 eingebrachten Dichtungsnut ein Dichtring 13 eingesetzt.

Auf der Elektrikplatte 2 sind drei radial zu dem Zentralstecker 5 angeordnete Zentrier- und Befestigungsbuchsen 14 angeordnet, von denen in den Figuren nur eine gezeigt ist. Diese Zentrier- und Befestigungsbuchsen 14 dienen zur eindeutigen Anordnung der Abdeckung 3 sowie zur Befestigung derselben mit der Elektrikplatte 2. Zu diesem Zweck sind der Abdekkung 3 an mit den Zentrier- und Befestigungsbuchsen 14 entsprechenden Positionen nach unten abragenden Kerbnagel ähnlich wirkende Elemente 15 vorgesehen. In die Abdeckung 3 ist eine Durchlaßöffnung 16 eingebracht, durch die im montierten Zustand der Anordnung 1 die Führungshülse 11 hindurchgreift. Dabei ist vorgesehen, daß die lichte Weite der Durchlaßöffnung 16 kaum größer als der Außendurchmesser der Führungshülse 11 ist. Zur Abdichtung des zwischen der Durchlaßöffnung 16 und der Führungshülse 11 befindlichen Ringspaltes ist ein Dichtring 17 vorgesehen.

In die Führungshülse 11 ist ein Buchsengehäuse 18 mit einer der Anzahl der Kontaktstifte 6, 6' entsprechenden Anzahl an Buchsenkammern 19, 19' eingesetzt, in denen die in den Figuren nicht näher dargestellten buchsenseitigen elektrischen Kontaktmittel angeordnet sind. Mit Hilfe dieser Kontaktmittel ist ein elektrischer Kontakt zwischen den Kontaktstiften 6, 6' und der aus mehreren einzelnen Adern 20, 20' bestehenden Anschlußleitung 21 herstellbar. Das Buchsengehäuse 18 weist oberseitig einen an diesem geführten Bajonettring 22 zur Verriegelung des Buchsengehäuses 18 mit der Führungshülse 11 auf. Fußseitig trägt der Bajonettring 22 einen Ringflansch auf, der sich im montierten Zustand auf der Oberseite der Abdeckung 3 abstützt und somit als Spritzschutz zur Abdeckung der oberen Öffnung der Durchlaßöffnung 16 dient.

Die Elektrikplatte 2 stützt sich unterseitig mit Hilfe von Ausgleichsfedem 24, 24' an einer Gehäusewand 25 ab. Durch die Ausgleichsfedern 24, 24' ist die Elektrikplatte 2 im unmontierten Zustand schwimmend auf dem Gehäuseboden 25 gelagert und kann somit sowohl in vertikaler als auch in horizontalen Richtungen spannungsfrei bewegt und eingerichtet werden.

Eine Montage der Anordnung 1 erfolgt dadurch, daß zunächst die Elektrikplatte 2 auf dem Gehäuseboden 25, beispielsweise dem Gehäuse eines Kraftfahrzeuggetriebes schwimmend angeordnet wird. Bevor die Abdeckung 3 auf der Elektrikplatte 2 fixiert wird, kann das Getriebe hinsichtlich seiner elektrischen bzw. elektronischen Funktions- und Steuerfähigkeit durch Anschließen einer entsprechenden Anschlußleitung an dem Zentralstecker 5 getestet werden. Nach Feststellen einer ordnungsgemäßen Funktionsweise wird dieser Stecker wieder entfernt und es wird die Führungshülse 11 durch Einschieben derselben in die Ringnut 10 und Fixieren der Führungshülse 11 mit Hilfe der Bügelklammer 12 an dem Steg 8 montiert. In einem nächsten Montageschritt wird die Abdeckung 3 dergestalt über die Elektrikplatte 2 gesetzt, daß die Elemente 15 mit den jeweiligen Zentrier- und Befestigungsbuchsen 14 fluchten. Zur besseren Zentrierwirkung sind daher die Elemente 15 vorderseitig konisch verjüngt ausgebildet. Durch das Einführen der Elemente 15 in die Zentrier- und Befestigungsbuchsen 14 der Elektrikplatte 2 erfolgt sowohl eine Zentrierung der Elektrikplatte 2 bzw. der Führungshülse 11 bezüglich der Durchlaßöffnung 16 als auch eine feste mechanische Verbindung zwischen der Abdeckung 3 und der Elektrikplatte 2. Diese Verbindung ist nach Abschluß dieses Montageschrittes durch den Preßsitz der Elemente 15 in den Zentrier- und Befestigungsbuchsen 14 gewährleistet. Anhand dieses Montageschrittes wird deutlich, daß Toleranzen hinsichtlich der Anordnung der Durchlaßöffnung 16 und der auf dem Gehäuseboden 25 vormontierten Elektrikplatte 2 durch die schwimmende Lagerung der Elektrikplatte 2 spannungsfrei ausgleichbar sind. Entsprechend exakt kann der Durchmesser der Durchlaßöffnung 16 auf den Außendurchmesser der Führungshülse 11 abgestimmt sein. Femer wird deutlich, daß Vibrationen nicht zu einer Beschädigung der Steckverbindung 4 führen können.

In einem letzten Montageschritt wird das Buchsengehäuse 18 in die Führungshülse 11 eingesetzt und mit Hilfe des Bajonettringes 22 an der Führungshülse 11 verriegelt. Dem Buchsengehäuse 18 ist ferner eine Verriegelungsplatte 26 zugeordnet, mit der eine Verriegelung zwischen dem Buchsengehäuse 18 und den Kontaktstiften 6, 6' herstellbar ist.

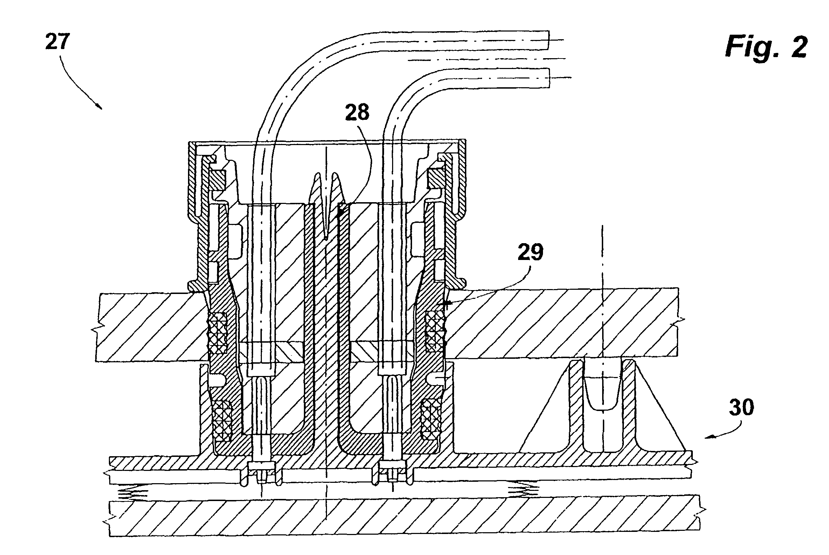

Figur 2 zeigt eine weitere Anordnung 27, bei der anstelle des in Figur 1 zur Verriegelung der Führungshülse 11 an dem Steg 8 vorgesehenen Bügelklammer 12 ein zentraler Verriegelungszapfen 28 vorgesehen ist. Bei einer solchen Verriegelung der Führungshülse 29 mit der Elektrikplatte 30 erfolgt die Verriegelung selbsttätig, nämlich dann, wenn die Führungshülse 29 ausreichend weit eingeschoben worden ist.

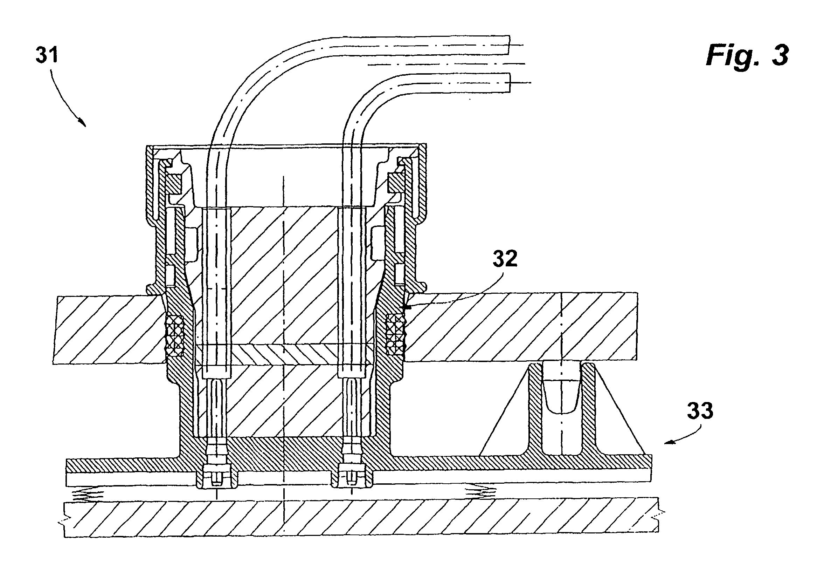

Bei einer weiteren Anordnung 31 ist, wie in Figur 3 gezeigt, die Führungshülse 32 an der Elektrikplatte 33 angeformt. Bei einer solchen Ausgestaltung entfällt die untere Abdichtung zwischen der Führungshülse und dem der Elektrikplatte zugeordneten Steg, wie bei den Ausgestaltungen der Figuren 1 und 2.

### Zusammenstellung der Bezugszeichen

- 1: Anordnung
- 2: Elektrikplatte
- 3: Abdeckung
- 4: Elektrischer Steckverbinder
- 5: Zentralstecker
- 6, 6': Kontaktstifte
- 7, 7': Nietbolzen
- 8: Steg
- 9: Boden
- 10: Nut
- 11: Führungshülse
- 12: Bügelklammer
- 13: Dichtring
- 14: Zentrier- und Befestigungsbuchse
- 15: Kerbnagel ähnlich wirkendes Element
- 16: Durchlaßöffnung
- 17: Dichtring
- 18: Buchsengehäuse
- 19, 19': Buchse
- 20, 20': Ader
- 21: Anschlußleitung
- 22: Bajonettring
- 23: Ringflansch
- 24, 24': Ausgleichsfeder
- 25: Gehäuseboden
- 26: Verriegelungsplatte
- 27: Anordnung
- 28: Verriegelungszapfen
- 29: Führungshülse
- 30: Elektrikplatte
- 31: Anordnung
- 32: Führungshülse
- 33: Elektrikplatte

## Patentansprüche

1. Anordnung betreffend eine elektrische und/oder elektronische Bauelemente tragende Elektrikplatte (2, 30, 33) mit einem elektrischen Steckverbinder (4) und mit einer die Elektrikplatte (2, 30, 33) bedeckenden Abdeckung (3), welche Elektrikplatte (2, 30, 33) unterhalb der Abdeckung (3) angeordnet ist und welcher Steckverbinder (4) zur Herstellung einer elektrischen Verbindung zwischen der Elektrikplatte (2, 30, 33) zugeordneten Leiterbahnen und einer Anschlußleitung (21) vorgesehen ist und eine von der Elektrikplatte (2, 30, 33) abragende Anordnung erster Kontaktglieder (6, 6') umfaßt, mit welchen Kontaktgliedem (6, 6') die freien Enden der elektrischen Leiterbahnen verbunden sind, sowie eine an dem einen Ende einer Anschlußleitung (21) befindliche, zur Erstellung einer elektrischen Verbindung mit den ersten Kontaktgliedern (6, 6') ausgebildete Anordnung von zweiten Kontaktgliedem (19, 19') umfaßt, welchem Steckverbinder (4) eine durch eine Durchlaßöffnung (16) der Abdeckung (3) geführte Führungshülse (11, 29, 32) mit außenseitig angeordneten Dichtmitteln (17) zur Abdichtung der Führungshülse (11, 29, 32) gegenüber der Abdeckung (3) zugeordnet ist, **dadurch gekennzeichnet, daß** an der von der Abdeckung adgewandten Seite der Elektrikplatte (2, 30, 33) nachgiebige Abstützelemente (24, 24') vorgesehen sind und daß der Elektrikplatte (2, 30, 33) und der Abdeckung (3) jeweils zusammenwirkende Befestigungsmittel (14, 15) zur Erstellung einer mechanischen Verbindung zwischen der Elektrikplatte (2, 30, 33) und der Abdeckung (3) zugeordnet sind.

2. Anordnung nach Anspruch 1, **dadurch gekennzeichnet, daß** die Befestigungsmittel (14, 15) in radialer Anordnung zur Anordnung der ersten Kontaktglieder (6, 6') angeordnet sind.

3. Anordnung nach Anspruch 1 oder 2, **dadurch gekennzeichnet, daß** als Befestigungsmittel der Elektrikplatte (2, 30, 33) Buchsen (14) zugeordnet sind, in die an der Abdeckung (3) angeformte Kerbnagel ähnlich wirkende Elemente (15) eingreifen.

4. Anordnung nach Anspruch 2 und 3, **dadurch gekennzeichnet, daß** der Anordnung (1) drei derartiger Befestigungsmittel (14, 15) zugeordnet sind.

5. Anordnung nach einem der Ansprüche 1 bis 4, **dadurch gekennzeichnet, daß** als nachgiebige Abstützelemente der Elektrikplatte (2, 30, 33) Schraubenfedern (24, 24') vorgesehen sind.

6. Anordnung nach einem oder mehreren der Ansprüche 1 bis 5, **dadurch gekennzeichnet, daß** die Führungshülse (32) an der Elektrikplatte (33) angeformt ist.

7. Anordnung nach einem oder mehreren der Ansprüche 1 bis 5, **dadurch gekennzeichnet, daß** die Führungshülse (11, 29) mit der Elektrikplatte (2, 30) durch rastend wirkende Befestigungsmittel (12, 28) verbindbar ist.

8. Anordnung nach einem oder mehreren der Ansprüche 1 bis 7, **dadurch gekennzeichnet, daß** die zweiten Kontaktglieder in einem Gehäuse (18) aufgenommen sind, das mit einem Bajonettring (22) an der Führungshülse (11, 29, 32) verriegelbar ist.

9. Anordnung nach einem oder mehreren der Ansprüche 1 bis 8, **dadurch gekennzeichnet, daß** als erste Kontaktglieder Kontaktstifte (6, 6') und als zweite Kontaktglieder Buchsen (19, 19') vorgesehen sind.

## Claims

1. Assembly for an electric circuit board (2, 30, 33), which carries electrical and/or electronic components, said assembly including an electrical plug-in connector (4) and a covering (3), which covers the electric circuit board (2, 30, 33), which electric circuit board (2, 30, 33) is disposed beneath the covering (3), and which plug-in connector (4) is provided in order to establish an electrical connection between conductor paths, associated with the electric circuit board (2, 30, 33), and a connecting line (21), and said connector includes an arrangement of first contact members (6, 6') which protrudes from the electric circuit board (2, 30, 33), the free ends of the electrical conductor paths being connected to said contact members (6, 6'), as well as said connector including an arrangement of second contact members (19, 19'), which is situated at one end of a connecting line (21) and is provided in order to establish an electrical connection with the first contact members (6, 6'), which plug-in connector (4) has associated therewith a guide sleeve (11, 29, 32), which extends through a through-aperture (16) in the covering (3) and has externally disposed sealing means (17) for sealing the guide sleeve (11, 29, 32) from the covering (3), **characterised in that** resilient supporting members (24, 24') are provided on the side of the electric circuit board (2, 30, 33) remote from the covering, and **in that** the electric circuit board (2, 30, 33) and the covering (3) each have associated therewith co-operating securing means (14, 15) for establishing a mechanical connection between the electric circuit board (2, 30, 33) and the covering (3).

2. Assembly according to claim 1, **characterised in that** the securing means (14, 15) are disposed in a radial disposition relative to the arrangement of the first contact members (6, 6').

3. Assembly according to claim 1 or 2, **characterised in that** bushes (14) are associated with the electric circuit board (2, 30, 33) as the securing means, and members (15), which are provided on the covering (3) and act like a notched nail, engage in said bushes.

4. Assembly according to claims 2 and 3, **characterised in that** three such securing means (14, 15) are associated with the assembly (1).

5. Assembly according to one of claims 1 to 4, **characterised in that** helical springs (24, 24') are provided as the resilient supporting members of the electric circuit board (2, 30, 33).

6. Assembly according to one or more of claims 1 to 5, **characterised in that** the guide sleeve (32) is provided on the electric circuit board (33).

7. Assembly according to one or more of claims 1 to 5, **characterised in that** the guide sleeve (11, 29) is connectable to the electric circuit board (2, 30) by locking securing means (12, 28).

8. Assembly according to one or more of claims 1 to 7, **characterised in that** the second contact members are accommodated in a housing (18), which is lockable with a bayonet ring (22) on the guide sleeve (11, 29, 32).

9. Assembly according to one or more of claims 1 to 8, **characterised in that** contact pins (6, 6') are provided as the first contact members, and bushes (19, 19') are provided as the second contact members.

## Revendications

1. Assemblage pour un circuit imprimé (2, 30, 33) comprenant des composants électriques et/ou électroniques, un connecteur électrique (4) ainsi qu'un couvercle (3) recouvrant le circuit imprimé (2, 30, 33), lequel circuit imprimé (2, 30, 33) se trouve sous le couvercle (3), avec un connecteur électrique (4) prévu pour établir une connexion électrique entre les pistes conductrices constituant le circuit imprimé et une conduite de raccordement (21) et qui comprend un assemblage de premiers éléments de contacts (6, 6') disposés de manière saillante sur le circuit imprimé (2, 30, 33), éléments de contacts (6, 6') auxquels sont raccordées les extrémités libres des pistes conductrices électriques, ainsi qu'un assemblage de seconds éléments de contact (19, 19') se trouvant à une extrémité de la conduite de connexion (21), conçu pour établir une liaison électrique avec les premiers éléments de contact 6, 6', dont le connecteur enfichable (4) supporte une douille de guidage (11, 29, 32) qui passe à travers une ouverture (16) laissée dans le couvercle (3) ainsi que des moyens d'étanchéité (17) disposés à l'extérieur pour étancher la douille de guidage (11, 29, 32) par rapport au couvercle (3) **caractérisé en ce que** sont prévus sur le côté opposé au couvercle (3) du circuit imprimé (2, 30, 33) des éléments supports (24, 24') flexibles et que le circuit imprimé (2, 30, 33) et le couvercle (3) soient munis de moyens de fixation (14, 15) agissant solidairement dans le but d'établir une jonction mécanique entre le circuit imprimé (2, 30, 33) et le couvercle (3).

2. Assemblage selon la revendication 1, **caractérisé en ce que** les moyens de fixation (14, 15) sont disposés radialement par rapport à la disposition des premiers éléments de contact (6, 6').

3. Assemblage selon la revendication 1 ou 2, **caractérisé en ce que** le circuit imprimé (2, 30, 33) comporte des douilles (14) en guise de moyens de fixation, qui s'engagent sur des éléments (15) moulés sur le couvercle (3) et ayant des fonctions similaires à celles d'un clou cannelé.

4. Assemblage selon la revendication 2 et 3, **caractérisé en ce que** l'assemblage (1) comprend trois de ces moyens de fixation (14, 15).

5. Assemblage selon l'une des revendications 1 à 4, **caractérisé en ce que** des ressorts à boudin (24, 24') sont prévus pour faire office d'éléments supports flexibles du circuit imprimé (2, 30, 33).

6. Assemblage selon une ou plusieurs des revendications 1 à 5, **caractérisé en ce que** la douille de guidage (32) est moulée sur le circuit imprimé (33).

7. Assemblage selon une ou plusieurs des revendications 1 à 5, **caractérisé en ce que** la douille de guidage (11, 29) peut être rattachée au circuit imprimé (2, 30) par des moyens de fixation agissant par enclenchement.

8. Assemblage selon une ou plusieurs des revendications 1 à 7, **caractérisé en ce que** les seconds éléments de contact sont intégrés dans un logement (18) qui est verrouillable à l'aide d'une bague baïonnette (22) sur la douille de guidage (11, 29, 32).

9. Assemblage selon une ou plusieurs des revendications 1 à 8, **caractérisé en ce que** les premiers éléments de contact sont des tiges de contact (6, 6') et que les seconds éléments de contact sont des douilles (19, 19').
